Europäisches Patentamt

European Patent Office

Office européen des brevets

(11) Veröffentlichungsnummer: **0 364 019**

**A1**

## (12) EUROPÄISCHE PATENTANMELDUNG

(21) Anmeldenummer: 89202424.1

(22) Anmeldetag: 27.09.89

(51) Int. Cl.⁵: **G01R 33/42**

(30) Priorität: 03.10.88 DE 3833592

(43) Veröffentlichungstag der Anmeldung:
18.04.90 Patentblatt 90/16

(84) Benannte Vertragsstaaten:
**DE FR GB NL**

(71) Anmelder: **Philips Patentverwaltung GmbH**
**Wendenstrasse 35 Postfach 10 51 49**
**D-2000 Hamburg 1(DE)**
(84) **DE**

Anmelder: **N.V. Philips' Gloeilampenfabrieken**
**Groenewoudseweg 1**
**NL-5621 BA Eindhoven(NL)**
(84) **FR GB NL**

(72) Erfinder: **Alich, Thomas**
Hermelinweg 14a
D-2200 Elmshorn(DE)
Erfinder: **Flisikowski, Peter**
**Joachim-Mähl-Strasse 1a**
**D-2000 Hamburg 61(DE)**
Erfinder: **Peemöller, Horst**
**Bengelsdorfstrasse 2**
**D-2000 Hamburg 71(DE)**
Erfinder: **Möser, Michael, Dr. Ing. habil.**
**Baymestrasse 12**
**D-1000 Berlin 41(DE)**

(74) Vertreter: **Kupfermann, Fritz-Joachim,**
**Dipl.-Ing. et al**
**Philips Patentverwaltung GmbH**
**Wendenstrasse 35 Postfach 10 51 49**
**D-2000 Hamburg 1(DE)**

(54) Vorrichtung zur Geräuschdämpfung und Hochfrequenz-Abschirmung des Patienten-Aufnahmeraumes im Feld des Magneten eines MR-Tomographiegerätes.

(57) Die Erfindung bezieht sich auf eine Vorrichtung zur Geräuschdämpfung und Hochfrequenz-Abschirmung des Patienten-Aufnahmeraumes (22) im Feldraum eines Magneten (3) eines MR-Tomographiegerätes mit einem Kunststoffträgerrohr (5), das einen zylinderförmigen Hohlraum (9) des Magneten (3) in axialer Richtung durchsetzt. Die Vorrichtung ist gekennzeichnet durch
- Abschirmrohr-Endabschnitte (11a, 11b) aus Kunststoff im Bereich der axialen Trägerrohrenden (5a, 5b), die innerhalb des Tragrohres von diesen beiden Enden teilweise bis in das Innere des Magnethohlraumes (9) hineinreichen und vom Trägerrohr (5) getragen werden,
- einen aus Kunststoff bestehenden Abschirmrohr-Mittelabschnitt (16) kleineren Durchmessers als die Endabschnitte (11a, 11b), der von den Endabschnitten koaxial zu diesen getragen wird,
- elastische Übergangsteile zwischen den Endabschnitten (11a, 11b) und dem Mittelabschnitt (16),
- eine Hochfrequenz-Abschirmung (20), die sich zwischen den äußeren Enden (12a, 12b) der Endabschnitte (11a, 11b) über den Mittelabschnitt (16) hinweg erstreckt und die Außenseiten der Abschnitte (11a, 11b, 16) und Übergangsteile (13) bedeckt.

Fig. 1

## Vorrichtung zur Geräuschdämpfung und Hochfrequenz-Abschirmung des Patienten-Aufnahmeraumes im Feldraum eines Magneten eines MR-Tomographiegerätes

Die Erfindung bezieht sich auf eine Vorrichtung zur Geräuschdämpfung und Hochfrequenz-Abschirmung des Patienten-Aufnahmeraumes im Feldraum eines Magneten eines MR-Tomographiegerätes mit einem Kunststoffträgerrohr, das einen zylinderförmigen Hohlraum des Magneten in axialer Richtung durchsetzt.

In dem zylinderförmigen Hohlraum des Magneten eines MR-Tomographiegerätes herrscht, insbesondere wenn es sich um einen 4-Tesla-Magneten handelt, ein relativ hoher Geräuschpegel, der von einem Patienten als unangenehm empfunden wird. Durch den aus der EP-A 157 404 bekannten Einsatz eines den Hohlraum des Magneten in voller Länge durchsetzenden Trägerrohres aus glasfaserverstärktem Kunststoff erfolgt eine Geräuschdämpfung, die allerdings nur bei Geräten geringerer Leistung ausreicht. Die HF-Abschirmung des Magnetfeldes ist bei der bekannten Anordnung auf der Innenwand des glasfaserverstärkten Kunststoffrohres angebracht. Bei den während des Betriebes auftretenden Schwingungen neigt die Abschirmung dazu, sich von der Unterlage zu lösen. Ein weiterer Nachteil besteht darin, daß die Verbindungslötungen der Abschirmung innerhalb Tomographen durchgeführt werden müssen. Dadurch wird die Demontierbarkeit erschwert.

Es ist Aufgabe der Erfindung, eine Vorrichtung der eingangs erwähnten Art zu schaffen, mittels der der Lärmpegel innerhalb des Patienten-Aufnahmeraumes im Feld des Magneten deutlich reduziert wird und mittels der zugleich eine funktionssichere, lösbare Hochfrequenz-Abschirmung geschaffen wird.

Die gestellte Aufgabe ist erfindungsgemäß gelöst durch
- Abschirmrohr-Endabschnitte aus Kunststoff im Bereich der axialen Trägerrohrenden, die innerhalb des Trägerrohres von diesen beiden Enden teilweise bis in das Innere des Magnethohlraumes hinein reichen und vom Trägerrohr getragen werden,
- einen aus Kunststoff bestehenden Abschirmrohr-Mittelabschnitt kleineren Durchmessers als die Endabschnitte, der von den Endabschnitten koaxial zu diesen getragen wird,
- elastische Übergangsteile zwischen den Endabschnitten und dem Mittelabschnitt,
- eine Hochfrequenz-Abschirmung, die sich zwischen den äußeren Enden der Endabschnitte über den Mittelabschnitt hinweg erstreckt und die Außenseiten der Abschnitte und Übergangsteile bedeckt.

Die Abschirmrohr-Endabschnitte, die zwischen sich einen Abschirmrohr-Mittelabschnitt geringeren Durchmessers tragen, sorgen, wenn das Tragrohr und die Rohrabschnitte aus glasfaserverstärktem Kunststoff (GFK) bestehen, für eine deutliche Verschiebung des Resonanzbereiches zu höheren Frequenzen, die von einem Patienten als angenehm empfunden wird. Dies wird dadurch begünstigt, daß der Bereich, in dem sich der Patient befindet, durch den Mittelrohrabschnitt noch einmal zusätzlich gegenüber dem Trägerrohr abgesetzt ist. Dies führt zu einer besseren akustischen Entkopplung, die für den Patienten geräuschdämpfend wirkt.

Nach einer weiteren Ausgestaltung der Erfindung ist vorgesehen, daß zwischen den Abschirmrohr-Endabschnitten und dem diese umschließenden Trägerrohr eine Gummiisolierung vorgesehen ist. Eine solche Gummiisolierung zwischen den Mittelrohr-Endabschnitten und dem Trägerrohr führt zu einer weiteren akustischen Entkopplung und damit Geräuschdämpfung.

Wenn die Abschirmung immer auf den Außenseiten der Endabschnitte und des Mittelabschnittes vorgesehen sind, dann liegen sie unverrückbar fest und können nicht abfallen. Die Rohrwandungen stellen eine einwandfreie Stütze dar. Besonders günstig liegt die Abschirmung, wenn im Bereich der Abschirmrohr-Endabschnitte die Abschirmung unmittelbar auf dem Rohr und unterhalb der Gummiisolierung vorgesehen ist.

Nach einer weiteren Ausgestaltung der Erfindung ist vorgesehen, daß die äußeren Enden des Abschirmrohr-Mittelabschnittes mit den inneren Enden der Abschirmrohr-Endabschnitte über den Durchmesserunterschied ausgleichende, als Übergangsteile wirkende, ringscheibenförmige Gummiflansche verbunden sind. Derartige ringscheibenförmige Gummiflansche entkoppeln zusätzlich die auf den Abschirmrohr-Mittelabschnitt übertragenen Schwingungen und sorgen damit auch ihrerseits für eine weitere Geräuschdämpfung.

Nach einer weiteren Ausgestaltung der Erfindung ist vorgesehen, daß die Abschirmungen auf den inneren Enden der Endabschnitte und die Abschirmungen an den radial außen gelegenen Rändern der Gummiflansche miteinander verlötet und die Abschirmungen auf den radial innen gelegenen Rändern der Gummiflansche und den axialen Enden des Mittelabschnittes miteinander verpreßt sind. Während die Gummiflansche und die inneren Enden der Abschirmrohr-Endabschnitte durch das Zusammenlöten unlösbar miteinander verbunden sind, kann der Abschirmrohr-Mittelabschnitt beim Lösen der Preßverbindung herausgelöst werden.

Als Abschirmung kommt ein Messingdrahtgeflecht in Betracht mit einer Maschenweite von 0,35 mm.

Die Erfindung wird anhand der Zeichnung näher erläutert.

Es zeigen:

Fig. 1 eine Schnittdarstellung einer Patienten-Aufnahme im Magnethohlraum eines MR-Tomographiegerätes,

Fig. 2 einen Schnitt durch die Vorrichtung nach Fig. 1 längs der Linie II-II zur Darstellung des tragenden und isolierenden Aufbaues der Vorrichtung,

Fig. 3 den Übergang zwischen Abschirmrohr-Endabschnitten und Abschirmrohr-Mittelabschnitt mittels Gummiflanschen,

Fig. 4 den Übergang zwischen der Patienten-Aufnahme und dem außerhalb des Magneten befindlichen Patientenraumes,

Fig. 5 den dem Patientenraum gegenüberliegenden Endabschluß der Vorrichtung auf der anderen Seite des Magneten.

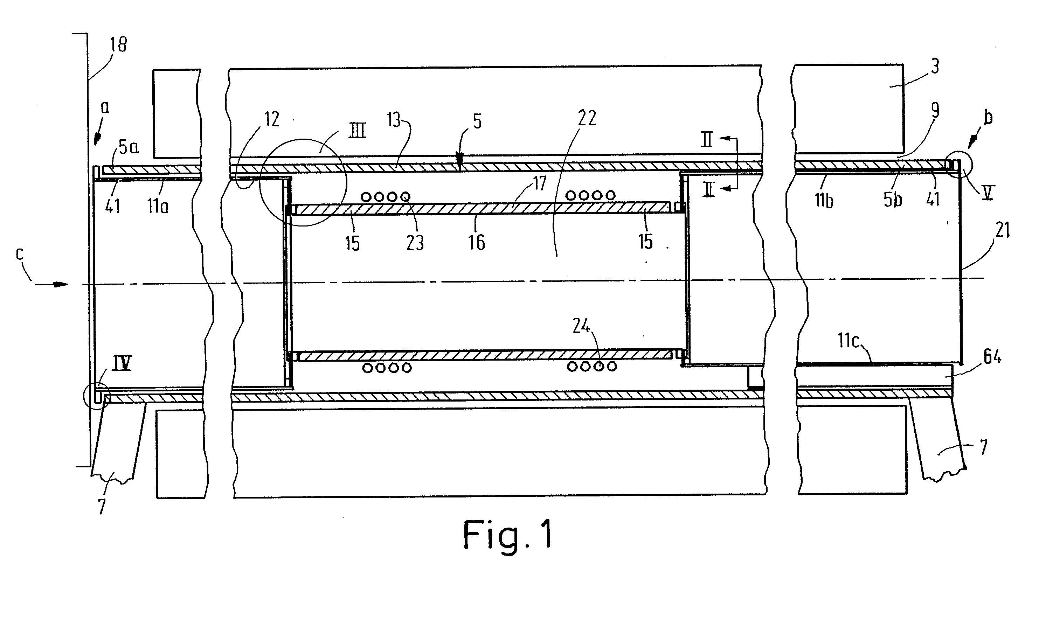

Die in Fig. 1 im Schnitt dargestellte Vorrichtung zur Geräuschdämpfung und HF-Abschirmung des PatientenAufnahmeraumes im Feld eines 4-Tesla-Magneten 3 weist als tragendes Teil ein Trägerrohr 5 aus glasfaserverstärktem Kunststoff auf, das an seinen axialen Enden 5a und 5b über nicht dargestellte justierbare Stellvorrichtungen an einem Traggestell 7 außerhalb des Magneten 3 am Boden abgestützt ist. Das Trägerrohr 5 ist deshalb ohne mechanischen Kontakt durch den Magnethohlraum 9 hindurch geführt.

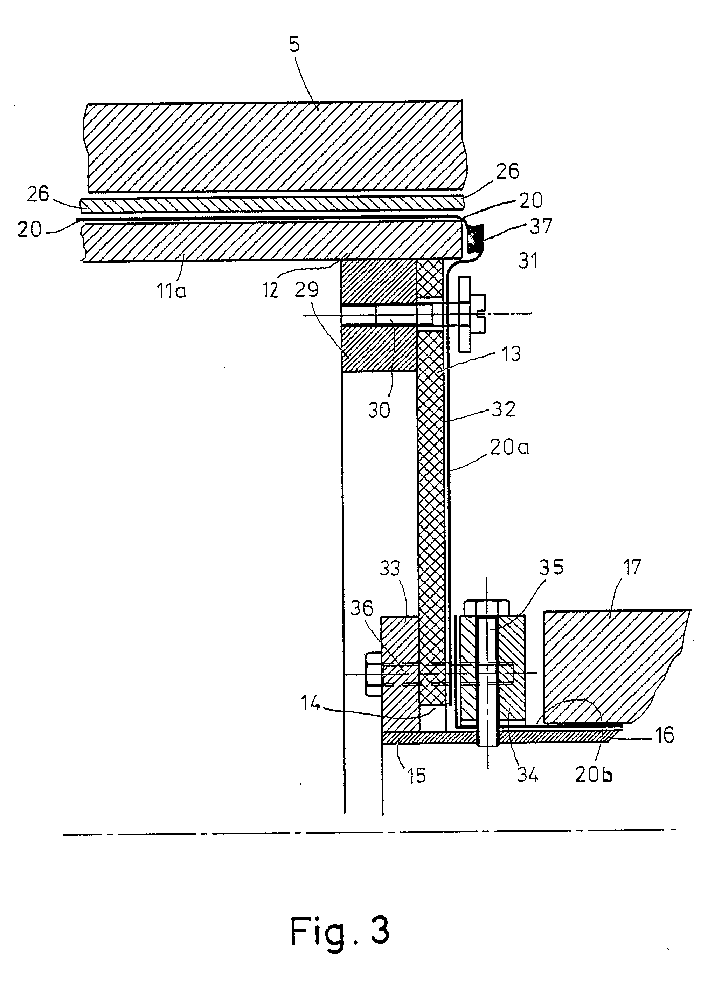

In den Bereichen der Trägerrohrenden 5a und 5b befinden sich innerhalb des Trägerrohres 5 Abschirmrohr-Endabschnitte 11a, 11b, die im Trägerrohr 5 getragen werden. Die innerhalb des Magneten 3 befindlichen Teile 12 der Abschirmrohr-Endabschnitte 11a und 11b sind auf in Fig. 3 näher beschriebene Weise mit ringscheibenförmigen Gummiflanschen 13 versehen, die im Bereich ihres Innenrandes 14 mit den axialen Enden 15 eines Abschirmrohr-Mittelabschnittes 16 verbunden sind. Der Abschirmrohr-Mittelabschnitt besteht ebenfalls aus glasfaserverstärktem Kunststoff. Der Abschirmrohr-Mittelabschnitt 16 wird umgeben von einem Gradientenrohr 17, welches ebenfalls aus glasfaserverstärktem Kunststoff besteht.

Die Abschirmrohr-Endabschnitte 11a, 11b und der Abschirmrohr-Mittelabschnitt 16 sind umgeben von einer Hochfrequenz-Abschirmung 20 aus einem Messingdrahtgewebe. Diese Abschirmung 20 ist auch auf der Außenseite über die Gummiflansche 13 hinweggezogen und verbindet damit die Abschirmung 20 der Endabschnitte 11a, 11b mit der Abschirmung 20b des Mittelabschnittes 16.

Der Patient wird auf einer nicht dargestellten Liege in Richtung eines Pfeile C aus einer Abschirmkammer 18 in die Vorrichtung hinein geschoben. Die Abschirmkammer 18 ist mit ihrer Abschirmung 19 gegenüber der Abschirmung 20 der Vorrichtung verbunden.

Der Abschirmkammer 18 gegenüber befindet sich ein Abschlußflansch 21, der den Patienten-Aufnahmeraum 22 nach außen hin verschließt.

Auf dem Gradientenrohr 17 sind, wie in Fig. 1 angedeutet ist, Gradientenspulen 23, 24 vorgesehen, die das Gradientenfeld bilden, innerhalb dessen die Untersuchungen an dem Patienten vorgenommen werden.

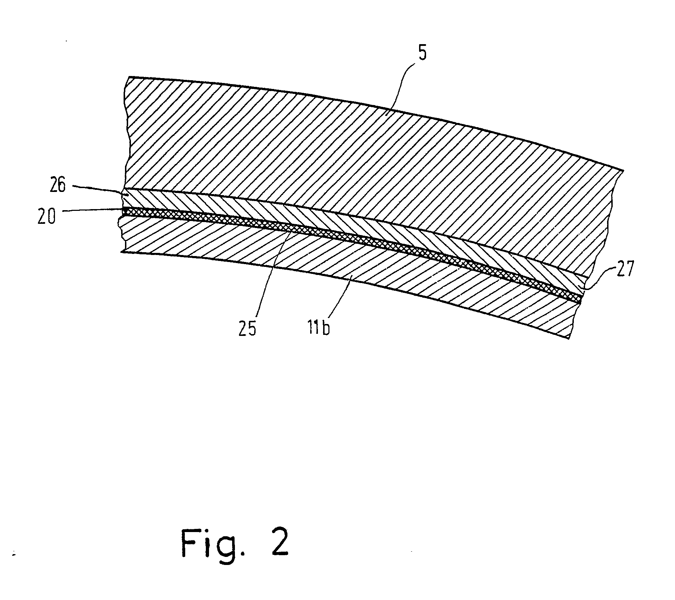

Fig. 2 zeigt im Schnitt II-II die Anordnung der Vorrichtung innerhalb des GFK-Trägerrohres 5. In dieses Trägerrohr ist der Abschirmrohr-Endabschnitt 11b eingeschoben, der auf seiner Außenseite 25 die HF-Abschirmung 20 trägt. Diese HF-Abschirmung 20 besteht aus einem Messingdrahtgewebe mit einer Maschenweite von 0,35 mm. Um die HF-Abschirmung 20 ist eine Gummiisolierung 26 gelegt, die an die Innenwand 27 des Trägerrohres 5 angepaßt ist.

Fig. 3 zeigt in vergrößerter Darstellung den Ausschnitt III nach Fig. 1. Man erkennt in Fig. 3, daß der Abschirmrohr-Endabschnitt 11a mit seinem inneren Ende 12, der aufgebrachten HF-Abschirmung 20 und der Gummiisolierung 26 im Trägerrohr 5 seinen Halt findet. Die Spalte zwischen den einzelnen Teilen sind lediglich zur Verbesserung der Übersichtlichkeit der Zeichnung dargestellt; in Wirklichkeit liegen die Teile 11a, 20, 26 und 5 unmittelbar aneinander an. In dem Ende 12 des Endabschnittes 11a befindet sich ein Ring 29 aus glasfaserverstärktem Kunststoff, an dem mittels einer Schraube 30 der Gummiflansch 13 mit seinem äußeren Rand 31 festgelegt ist. Auf die Außenseite 32 des ringscheibenförmigen Gummiflansches 13 ist ein in seiner Form dem Gummiflansch 13 etwa entsprechender ringscheibenförmiger Teil 20a der HF-Abschirmung aufgelegt.

Der Innenrand 14 des Gummiflansches 13 liegt zwischen einem Ring 33 aus glasfaserverstärktem Kunststoff, der auf das axiale Ende 15 des Abschirmrohr-Mittelabschnites 16 aufgesetzt ist. Ein weiterer GFK-Ring 34 ist mit dem Mittelabschnitt 16 verbunden. Der Ring 34 ist mittels radial verlaufender Schrauben 35 in den Abschirmrohr-Mittelabschnitt 16 eingeschraubt. Im Abstand von dem Ring 34 endet das Gradientenrohr 17. In axialer Richtung durch die GFK-Ringe 33 und 34 erstreckt sich eine Spannschraube 36, mit der die Ringe 33 und 34 und zwischen ihnen die Abschirmungen 20a und 20b sowie der Innenrand 14 des Gummiflansches 13 zusammenpreßbar sind. Auf diese Weise wird eine lösbare, jedoch gut leitfähige Verbindung zwischen Gummiflansch 13 und den Rohren 16 und 17 herbeigeführt. Für eine gleichmäßige Kraftverteilung sind um den Umfang des Randes 14 herum mehrere Schrauben 35 und 36 verteilt angeordnet. Das gleiche gilt auch für die Schrauben 30 am äußeren Rand 31 des Gummiflansches 13.

Während die elektrische Kontaktierung der Abschirmungsteile 20a und 20b im Bereich des Innenrandes 14 durch Pressen erfolgt, wird die Kontaktierung am Außenrand 31 des Gummiflansches 13 mittels einer Verlötung 37 herbeigeführt. Durch das Verpressen im Bereich des Innenrandes des Gummiflansches 13 ist es möglich, das Gradientenrohr 17 und den Abschirmrohr-Mittelabschnitt 16 bei Bedarf auszuwechseln.

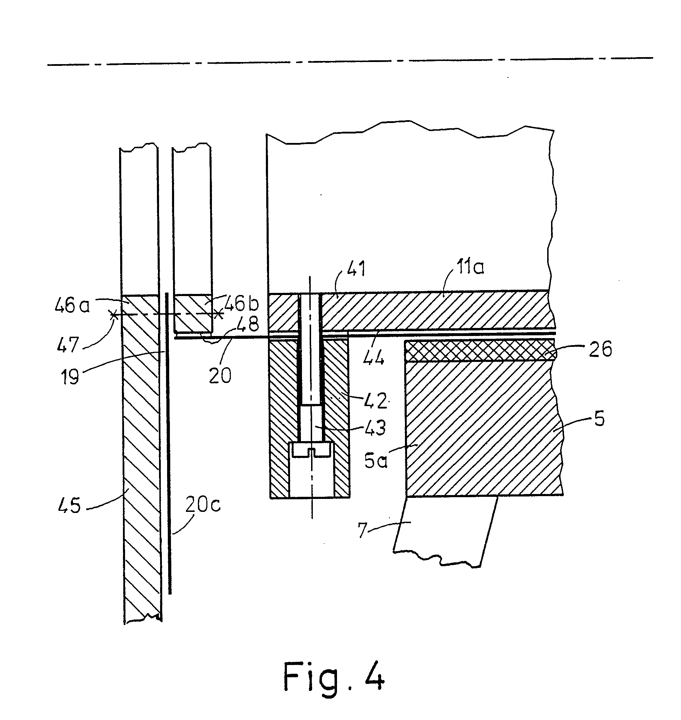

Fig. 4 zeigt den Anschluß der Abschirm- oder Patientenkammer 18 an die sich durch den Magneten 3 erstreckende Vorrichtung. Es ist erforderlich, diese Patienten- oder Abschirmkammer 18, in der sich auch Bedienungspersonal aufhalten muß, ebenso hochfrequenzmäßig von dem Magneten 3 abzuschirmen wie die Vorrichtung. Dazu wird der Endabschnitt 11a mit einem Stück 41 ein Stück über das äußere Ende 5a an der Seite a hinausgezogen. Auf das äußere Endstück 41 ist ein GFK-Ring 42 geschoben, der mittels einer radialen Schraube 43 mit dem Endstück 41 verschraubt ist. Die Abschirmung 20 zwischen der Außenseite 44 des Endabschnittes 11a und dem Ring 42 wird dabei pressend eingeklemmt. Vor dem Endstück 41 befindet sich eine Wand 45 der Abschirmkammer 18, die zu dem Endabschnitt 11a hin mit einer Abschirmung 20c versehen ist. Diese Abschirmung 20c ist zwischen zwei Kupferringen 46a und 46b mittels einer schematisch angedeuteten Schraubverbindung 47 einspannbar. Die Abschirmung 20 ist auf die Außenseite 48 des Kupferringes 46b aufgelötet. Auf diese Weise wird eine sichere, jedoch demontierbare Abschirmung zwischen der Abschirmkammer 18 und der Abschirmung 20 der Vorrichtung herbeigeführt.

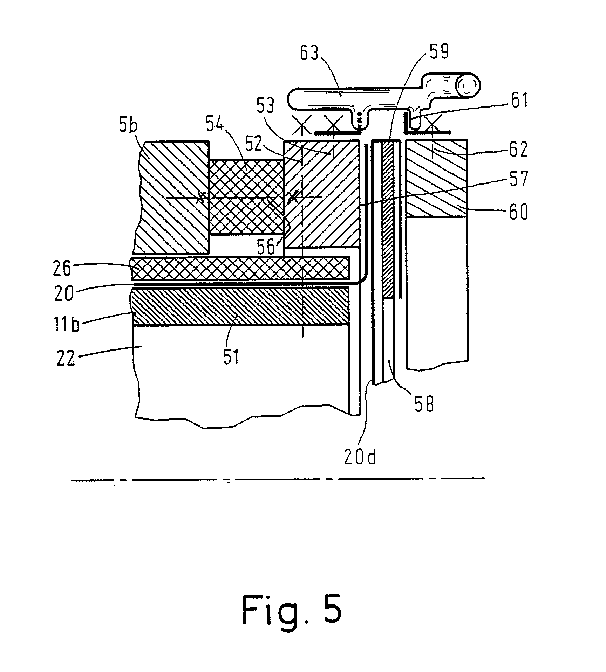

Fig. 5 zeigt den Aufbau des Abschlußflansches am Ende b der Vorrichtung nach Fig. 1. Das Trägerrohrende 5b umgibt wieder die Gummiisolierung 26, die HF-Abschirmung 20 und den Abschirmrohr-Endabschnitt 11b in einem Endbereich 51 außerhalb des Magneten 3. Der Endbereich 41 steht über das axiale Ende 5b des Trägerrohres 5 vor. Der Endbereich 41 wird umgeben von einem GFK-Verstärkungsring 52 aus glasfaserverstärktem Kunststoff, der mittels einer schematisch dargestellten Schraubverbindung 53 ringsherum mit radial vorstehenden Flanschen 54 verbunden ist. Zwischen dem GFK-Verstärkungsring 52 und dem axialen Trägerrohrende 5b befinden sich zwölf zylindrische Gummipuffer 55, die mittels schematisch dargestellter Schrauben 56 die axiale Sicherung des Endabschnittes 11b übernehmen. Die Abschirmung 20 ist über die außen gelegene Flanke 57 des Verstärkungsringes 52 hinweg gelegt. Ihr liegt außen ein Kupfer-Abschlußflansch 58 gegenüber, der zum Patienten-Innenraum 22 hin ganzflächig mit einer Abschirmung 20d versehen ist, die sich über den äußeren Rand 59 des Abschlußflansches 58 hinweg erstreckt. Als Außenabschluß des Abschlußflansches 58 dient ein weiterer Außen-Verstärkungsring 60 aus glasfaserverstärktem Kunststoff, der ebenfalls mit radial vorstehenden Winkeln 61 über eine schematisch dargestellte Schraubverbindung 62 verbunden ist. Beide radial nach außen vorstehenden Winkel 54, 61 sind mittels Gummi-Spannelementen 63 verbunden, die den Außen-Verstärkungsring 60 unter Kontaktierung des Kupfer-Abschlußflansches 58 mit der Abschirmung 20 und mit der Abschirmung 20d gegen den inneren Verstärkungsring 52 drückt.

Der Abschirmrohr-Endabschnitt 11b ist an seiner Unterseite 11c gegenüber dem Abschirmrohr-Endabschnitt 11a abgeflacht. Durch das Abflachen ergibt sich unterhalb der Unterseite 11c die Möglichkeit zur Anordnung eines Kabelkanales 64, der aus Fig. 1 zu ersehen ist und durch den Versorgungs- oder Meßzuleitungen zu dem Gradientenrohr 17 führbar sind.

## Ansprüche

1. Vorrichtung zur Geräuschdämpfung und Hochfrequenz-Abschirmung des Patienten-Aufnahmeraumes (22) im Feldraum eines Magneten (3) eines MR-Tomographiegerätes mit einem Kunststoffträgerrohr (5), das einen zylinderförmigen Hohlraum (9) des Magneten (3) in axialer Richtung durchsetzt, gekennzeichnet durch
- Abschirmrohr-Endabschnitte (11a, 11b) aus Kunststoff im Bereich der axialen Trägerrohrenden (5a, 5b), die innerhalb des Tragrohres von diesen beiden Enden teilweise bis in das Innere des Magnethohlraumes (9) hineinreichen und vom Trägerrohr (5) getragen werden,
- einen aus Kunststoff bestehenden Abschirmrohr-Mittelabschnitt (16) kleineren Durchmessers als die Endabschnitte (11a, 11b), der von den Endabschnitten koaxial zu diesen getragen wird,
- elastische Übergangsteile zwischen den Endabschnitten (11a, 11b) und dem Mittelabschnitt (16),
- eine Hochfrequenz-Abschirmung (20), die sich zwischen den äußeren Enden (12a, 12b) der Endabschnitte (11a, 11b) über den Mittelabschnitt (16) hinweg erstreckt und die Außenseiten der Abschnitte (11a, 11b, 16) und Übergangsteile (13) bedeckt.

2. Vorrichtung nach Anspruch 1, dadurch gekennzeichnet, daß das Trägerrohr (5) und die Abschirmrohrabschnitte (11a, 11b, 16) aus glasfaserverstärktem Kunststoff (GFK) bestehen.

3. Vorrichtung nach Anspruch 1, dadurch gekennzeichnet, daß zwischen den Abschirmrohr-Endabschnitten (11a, 11b) und dem diese umschließenden Trägerrohr (5) eine Gummiisolierung (26) vorgesehen ist.

4. Vorrichtung nach Anspruch 3, dadurch gekennzeichnet, daß zwischen der Gummiisolierung (26) und den Endabschnitten (11a, 11b) die Hochfrequenz-Abschirmung (20) vorgesehen ist.

5. Vorrichtung nach Anspruch 1, dadurch gekennzeichnet, daß die äußeren Enden (15) des Asbschirmrohr-Mittelabschnittes (16) mit den inneren Enden (12a) der Abschirmrohr-Endabschnitte (11a, 11b) über den Durchmesserunterschied ausgleichende, als Übergangsteile wirkende ringscheibenförmige Gummiflansche (13) verbunden sind.

6. Vorrichtung nach Anspruch 1 oder 5, daduch gekennzeichnet, daß die Abschirmungen (20) auf den inneren Enden (12a) der Endabschnitte (11a, 11b) und die Abschirmungen an den radial außen gelegenen Rändern (31) der Gummiflansche (13) miteinander verlötet und die Abschirmungen auf den radial innen gelegenen Rändern (14) der Gummiflansche (13) und den axialen Enden (15) des Mittelabschnittes (16) miteinander verpreßt sind.

7. Vorrichtung nach Anspruch 1, dadurch gekennzeichnet, daß das axial außen gelegene Ende (41) eines der Abschirmrohr-Endabschnitte (11b) mit einem lösbar angepreßten Abschlußflansch (21 versehen ist.

Fig. 1

Fig. 2

Fig. 3

Fig. 4

# Fig. 5

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| A,D | EP-A-0 157 404 (GENERAL ELECTRIC CO.) * Figuren 1,2; Seite 4, Zeile 26 - Seite 9, Zeile 32 * --- | 1,7 | G 01 R 33/42 |
| A | PATENT ABSTRACTS OF JAPAN, Band 10, Nr. 111 (P-451)[2168], 25. April 1986; & JP-A-60 242 350 (SANYO DENKI K.K.) 02-12-1985 ----- | 1 | |

RECHERCHIERTE SACHGEBIETE (Int. Cl.5)

A 61 B
G 01 R
H 05 K
G 01 N

Der vorliegende Recherchenbericht wurde für alle Patentansprüche erstellt

| Recherchenort | Abschlußdatum der Recherche | Prüfer |
|---|---|---|
| DEN HAAG | 21-12-1989 | CHEN A.H. |

EPO FORM 1503 03.82 (P0403)